# EUROPÄISCHE PATENTANMELDUNG

(11) **EP 2 878 697 A1**
(43) Veröffentlichungstag der Anmeldung: **03.06.2015**
(21) Anmeldenummer: 14187307.5
(22) Anmeldetag: 01.10.2014
(51) Int. Cl.: C23C 4/00, C23C 14/04, F01D 5/28, B05B 15/04

(54) **Verfahren zur Erzeugung einer Fase, Bauteil mit Fase und Vorrichtung**

(30) Priorität: 29.11.2013 DE 102013224568
(71) Anmelder: Siemens Aktiengesellschaft, 80333 München (DE)
(72) Erfinder: Brett, Tobias, 12529 Schönefeld (DE)

(57) **Zusammenfassung**

Durch entsprechende Abschattungsvorrichtungen wird die Beschichtung eines Substrats (4) mit einer Fase (10) im Bereich der Beschichtung (22) im Bereich einer Kante (13) erzeugt, so dass ein spannungsarmer Übergang zwischen der nicht zu beschichtenden Oberfläche (25) und der zu beschichtenden Oberfläche (7) gegeben ist.

## Beschreibung

Die Erfindung betrifft ein Beschichtungsverfahren, bei dem auf einer Oberfläche eines zu beschichtenden Bauteils eine Fase erzeugt wird, ein entsprechendes Bauteil und Vorrichtung.

Bauteile für den Hochtemperatureinsatz werden oft mit metallischen und/oder keramischen Schutzschichten versehen.

Insbesondere an Kanten kommt es zu Überhängen, die sehr genau eingestellt werden müssen.
Dies ist zeitaufwändig und schwierig in der Herstellung.

Es ist daher Aufgabe der Erfindung ein Verfahren, ein Bauteil und eine Vorrichtung aufzuzeigen, mit dem solche Probleme beseitigt werden.

Die Aufgabe wird gelöst durch ein Verfahren gemäß Anspruch 1, durch ein Bauteil gemäß Anspruch 3 und eine Vorrichtung gemäß Anspruch 7.

In den Unteransprüchen sind weitere vorteilhafte Maßnahmen aufgelistet, die beliebig miteinander kombiniert werden können, um weitere Vorteile zu erzielen.

Die Erfindung ermöglicht die einfache Erzeugung von Fasen und verbesserten Bauteilen.

Es zeigt:
- Figur 1, 2, 3: ein Bauteil und die Vorgehensweise beim Beschichten
- Figur 4: eine Turbinenschaufel

Die Figuren und die Beschreibung stellen nur Ausführungsbeispiele der Erfindung dar.

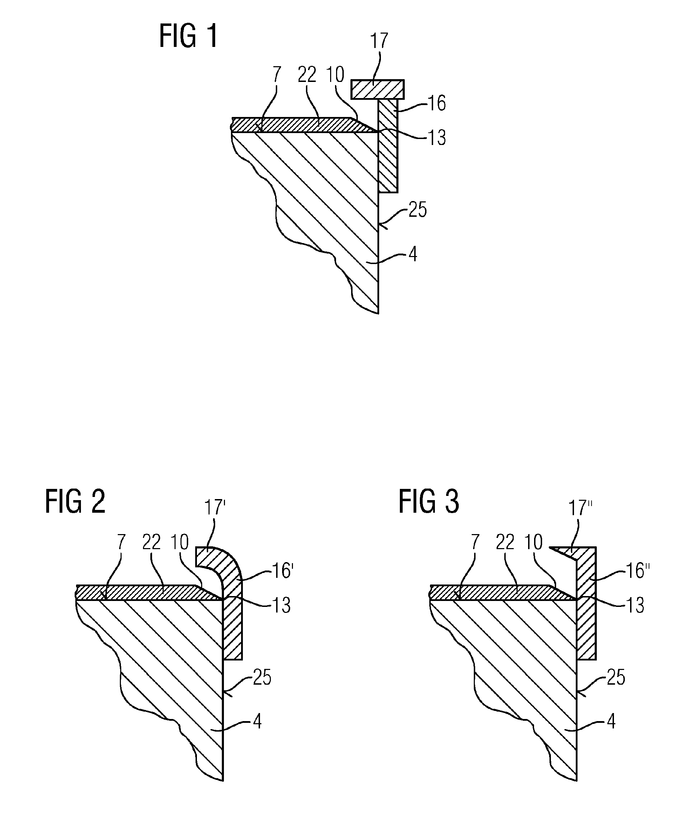

In der Figur 1 ist ein Substrat 4 mit einer zu beschichtenden Oberfläche 7 und einer nicht zu beschichtenden Oberfläche 25 dargestellt.

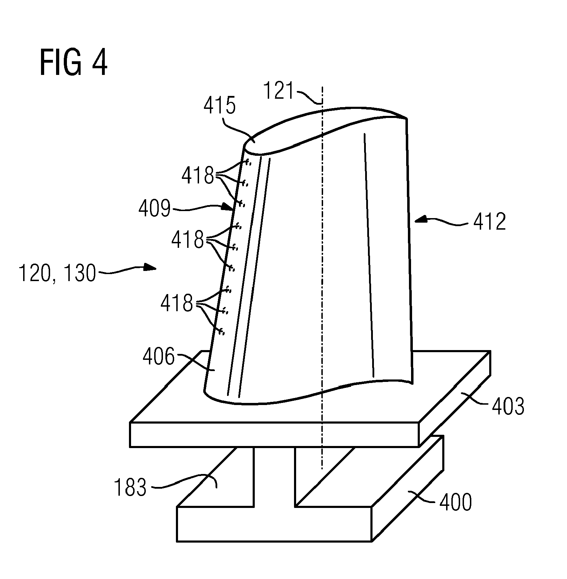

Das Substrat 4 ist vorzugsweise metallisch.
Bei Turbinenschaufeln 120, 130 (Fig. 4) weist das Substrat 4 eine nickel- oder kobaltbasierte Superlegierung auf.

Im Falle einer Turbinenschaufel 120, 130 als zu beschichtendes Substrat 4 stellt die zu beschichtende Fläche 7 zumindest die Plattform 403 (Fig. 4) dar und die nicht zu beschichtende Oberfläche 25 eine Seitenfläche der Plattform 403.

Auf der zu beschichtenden Fläche 7 wird zumindest eine Beschichtung 22 aus einem Metall, insbesondere aus einer MCrAlY-Legierung, und/oder einer Keramik erzeugt.

Das Substrat 4 weist eine Kante 13 zwischen der zu beschichtenden Oberfläche 7 und der nicht zu beschichtenden Oberfläche 25 auf, die vorzugsweise rechtwinklig ausgebildet ist.

Im Bereich dieser Kante 13 ist eine Fase 10 in der Beschichtung 22 vorhanden, die eine Abschrägung der Beschichtung 22 hin zur Kante 13 darstellt.
Die Fase 10 endet an der Kante 13.
Die Fase 10 ist insbesondere nur in der Beschichtung 22 ausgebildet.

Beim Beschichten wird dazu ein Wechselblech 16 verwendet, das an der nicht zu beschichtenden Oberfläche 25 direkt anliegt und über die zu beschichtende Oberfläche 7 in Längsrichtung 121 (Fig. 4) des Bauteils 4, 120, 130 hinausragt. Vorzugsweise kann am Ende des Wechselblechs 16 ein Überhang, vorzugsweise quer zu dem Wechselblech 16, ein kurzer Querbalken 17 angeordnet sein, der das Substrat 4 im Bereich der Kante 13 weiterhin abschattet und vorzugsweise über die Kante 13 hinausragt.

Beim Beschichten wird auch schon von dem Wechselblech 16 alleine und vorzugsweise noch verstärkt durch den kurzen Querbalken 17 weniger Material im Bereich der Kante 13 aufgetragen, wodurch die Fase 10 erzeugt wird.

Ebenso kann das Ende 17' des Wechselblechs 16 zum beschichteten Bauteil 4 hinzugebogen sein (Fig. 2).

Als weitere Alternative kann das Ende des Wechselblechs 16 eine Verbreiterung 17'' aufweisen (Fig. 3). Der Winkel der Verdickung 17" beträgt vorzugsweise 40° und weist vorzugsweise eine Höhe von 1,5mm auf.

HVOF, Plasmaspritzverfahren wie APS, LPPS, andere thermische Spritzverfahren oder Vakuumprozesse werden hier vorzugsweise verwendet.

Dadurch entsteht generell ein spannungsarmer Übergang zwischen der Beschichtung 7 und der Kante 13 zu der nicht zu beschichtenden Oberfläche 25.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichtemachen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.
Die Dichte liegt vorzugsweise bei 95% der theoretischen Dichte.
Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8Al-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

## Patentansprüche

1. Verfahren
zur Herstellung eines beschichteten Substrats (4) mit einer Fase (10) am Rande einer Beschichtung (22) auf einer zu beschichtenden Fläche (7) des Substrats (4),
wobei die Fase (10) im Bereich einer Kante (13), insbesondere im Bereich einer rechtwinkligen Kante (13) des Substrats (4)
endet,
bei dem ein Wechselblech (16) an eine nicht zu beschichtende Oberfläche (25) unterhalb der Kante (13) angelegt wird und
wobei das Wechselblech (16) in seiner Längsrichtung über die Oberfläche der zu beschichtenden Fläche (7) hinausragt und Beschichtung der Fläche (7) des Substrats (4).

2. Verfahren nach Anspruch 1,
bei dem ein Überhang (17, 17', 17") am Ende des Wechselblechs (16) angeordnet ist,
der in Richtung der zu beschichtenden Oberfläche (7) ragt, insbesondere über die Kante (13) hineinragt,
aber nicht vollständig die Fläche (7) überragt.

3. Bauteil,
insbesondere hergestellt nach einem oder beiden der Ansprüche 1 oder 2,
bei dem zwischen einer zu beschichtenden Fläche (7) und einer nicht zu beschichtenden Oberfläche (25) eine Kante (13),
insbesondere eine rechtwinkelige Kante (13),
ausgebildet ist,
wobei eine Fase (10) im Bereich der Beschichtung (22) an der Kante (13) ausgebildet ist.

4. Bauteil nach Anspruch 3,
bei dem die Beschichtung (22) eine metallische und/oder keramische Beschichtung darstellt.

5. Bauteil nach einem oder beiden der Ansprüche 3 oder 4, bei dem ein Substrat (4) des Bauteils metallisch ist.

6. Bauteil nach einem oder mehreren der Ansprüche,
bei dem die Fase (10) nur in der Beschichtung (22) ausgebildet ist.

7. Vorrichtung,
insbesondere zur Durchführung eines Verfahrens nach Anspruch 1 oder 2,
ganz insbesondere zur Herstellung des Bauteils nach einem oder mehreren der Ansprüche 3, 4, 5 oder 6,
die eine Halterung für ein Substrat (4) des Bauteils aufweist und
ein Wechselblech (16),
das direkt an eine nicht zu beschichtende Oberfläche (25) des Substrats (4) anlegbar ist.

8. Vorrichtung nach Anspruch 7,
bei dem ein Überhang (17, 17', 17") am Ende des Wechselblechs (16) angeordnet ist,
der in Richtung der zu beschichtenden Oberfläche (7) ragt, insbesondere über die Kante (13) hineinragt.

9. Vorrichtung nach Anspruch 8,
dass der Überhang ein Querbalken (17) ist.

10. Vorrichtung nach Anspruch 9,
bei dem der Überhang eine Biegung (17') des Endes des Wechselblechs (16) darstellt.

11. Vorrichtung nach Anspruch 9,
bei dem der Überhang eine Verbreiterung (17'') des Endes des Wechselblechs (16) darstellt.

## Geänderte Patentansprüche

### Geänderte Patentansprüche gemäss Regel 137(2) EPÜ.

1. Verfahren
zur Herstellung eines beschichteten Substrats (4) mit einer Fase (10) am Rande einer Beschichtung (22) auf einer zu beschichtenden Fläche (7) des Substrats (4),
wobei die Fase (10) im Bereich einer Kante (13), insbesondere im Bereich einer rechtwinkligen Kante (13) des Substrats (4)
endet,
bei dem ein Wechselblech (16) an eine nicht zu beschichtende Oberfläche (25) unterhalb der Kante (13) angelegt wird und
wobei das Wechselblech (16) in seiner Längsrichtung über die Oberfläche der zu beschichtenden Fläche (7) hinausragt und Beschichtung der Fläche (7) des Substrats (4).

2. Verfahren nach Anspruch 1,
bei dem ein Überhang (17, 17', 17") am Ende des Wechselblechs (16) angeordnet ist,
der in Richtung der zu beschichtenden Oberfläche (7) ragt, insbesondere über die Kante (13) hineinragt,
aber nicht vollständig die Fläche (7) überragt.

3. Vorrichtung,
insbesondere zur Durchführung eines Verfahrens nach Anspruch 1 oder 2,
ganz insbesondere zur Herstellung des Bauteils nach einem oder mehreren der Ansprüche 3, 4, 5 oder 6,
die eine Halterung für ein Substrat (4) des Bauteils aufweist und
ein Wechselblech (16),
das direkt an eine nicht zu beschichtende Oberfläche (25) des Substrats (4) anlegbar ist.

4. Vorrichtung nach Anspruch 3,
bei dem ein Überhang (17, 17', 17") am Ende des Wechselblechs (16) angeordnet ist,
der in Richtung der zu beschichtenden Oberfläche (7) ragt, insbesondere über die Kante (13) hineinragt.

5. Vorrichtung nach Anspruch 4,
dass der Überhang ein Querbalken (17) ist.

6. Vorrichtung nach Anspruch 5,
bei dem der Überhang eine Biegung (17') des Endes des Wechselblechs (16) darstellt.

7. Vorrichtung nach Anspruch 6,
bei dem der Überhang eine Verbreiterung (17") des Endes des Wechselblechs (16) darstellt.
